# EUROPEAN PATENT SPECIFICATION

(11) **EP 2 618 643 B1**
(45) Date of publication and mention of the grant of the patent: **19.10.2016**
(21) Application number: 11857136.3
(22) Date of filing: 23.05.2011
(51) Int. Cl.: H05K 5/00, A62C 3/16, H05K 7/14

(54) **COMBINED AUTOMATIC-CONTROL ENERGY-SAVING SAFE MACHINE CABINET**
SICHERE MASCHINENKABINE MIT KOMBINIERTER AUTOMATISCHER STEUERUNG UND ENERGIEEINSPARUNG
BOÎTIER DE MACHINE SÛR COMBINÉ À ÉCONOMIE D'ÉNERGIE ET À COMMANDE AUTOMATIQUE

(30) Priority: 25.01.2011 CN 201110026991
(43) Date of publication of application: 24.07.2013
(73) Proprietor: Guangzhou Holdstorm Science & Technology Co., Ltd, Guangzhou, Guangdong 510663 (CN)
(72) Inventor: FU, Xiaole, Guangzhou Guangdong 510663 (CN)
(74) Representative: Zaboliene, Reda
(86) International application number: PCT/CN2011/000887
(87) International publication number: WO 2012/100388

(56) References cited:
- CN-A- 101 561 164
- CN-A- 101 790 300
- DE-B3-102006 010 360
- JP-A- H0 866 488
- US-A1- 2009 211 773
- US-A1- 2010 263 885
- US-B1- 6 317 053

## Description

A modular energy-efficient and safety network cabinet comprises: at least one cabinet body; a main blast pipe, used to transfer air between an air-conditioner and the cabinet body defining a recycle way that the air is in from the bottom of the cabinet body and out from the top of the cabinet body; at least one tributary blast pipe, connected the main blast pipe and the cabinet body; a fire extinguisher, disposed above the cabinet body and full with inert-gas; an induction pipe, connecting the fire extinguisher and the cabinet body; a force draft fan, disposed under the cabinet body; a return fan, disposed above the cabinet body; an exhaust smoke valve, disposed above the return fan; a control system, used to control the temperature and humidity of the cabinet body and to put out a fire.

### Description

### FIELD OF THE INVENTION

The present invention relates to an intelligent modular energy-efficient and safety network cabinet.

### BACKGROUND OF THE INVENTION

At present, larger data center and machine room are usually equipped with cabinets, the cooling capacity of the network cabinets and the firefighting gas should be set accordance with the area and volume of the room, e.g.: US 2009/211773 A1 (GOOCH RODGER J [US]) 27 August 2009 (2009-08-27). However, there are the following shortcomings: (1) to meet the needs of the machines, the air-conditioner should be precisely in constant temperature and constant humidity state, and since the area of the room is larger, the needs of the cooling capacity is too large to make a waste; (2) to meet the needs of putting out the fire of the whole room, the firefighting gas should be sufficient and this will make the cost high; (3) when the fire alarm occurs caused by the smoke sensor and temperature senor, the inert-gas will be ejected to the whole room in a rush, which makes all the equipment be out of service or even scrapped and causes the network failing work and the data losing, the worse situation is that when people are not aware of the damage, it may cause the people to be died of asphyxiation.

### SUMMARY OF THE INVENTION

One object of the present invention is to provide an intelligent modular energy-efficient and safety network cabinet. To achieve the aim, the following technical schemes are applied.

A modular energy-efficient and safety network cabinet comprises: at least one cabinet body; a main blast pipe, used to transfer air between an air-conditioner and the cabinet body; at least one tributary blast pipe, connected the main blast pipe and the cabinet body; a fire extinguisher, disposed above the cabinet body and full with inert-gas; an induction pipe, connecting the fire extinguisher and the cabinet body; a force draft fan, disposed under the cabinet body; a return fan, disposed above the cabinet body; an exhaust smoke valve, disposed above the return fan; a line inlet and outlet for strong-and-weak current, disposed at the bottom of the cabinet body; a control system, used to control the temperature and humidity of the cabinet body and to put out a fire.

In accordance with the present invention, the equipment are inside the cabinet. Only the inner space of the cabinet is taken into consideration in order to achieve the constant temperature and humidity working conditions. The common air-conditioners is used for the outside space of the cabinet, and this can decrease the total power consumption of the air conditioners, which saves energy. Otherwise, the firefighting gas depends on the inner space of each independent cabinet, when the common fire extinguisher is used for the outside space of the cabinet, so the total consumption volume of firefighting gas is reduced and the volume of reserve fire-fighting gas is decreased, what is more important is that it avoids the whole firefighting gas being released at the same time to make all the equipment be out of service or even scrapped and cause the network failing work and the data losing, or other unpredictable effects. The worse situation is that when people are not aware of the damage, it may cause the people to be died of asphyxiation, so the present invention is not only energy-saving, but also safe.

### DESCRIPTION OF THE DRAWINGS

In order to better illustrate the invention, preferred embodiment combined the manual illustrated is following.
FIG.1 is the structure stereogram of part of the intelligent modular energy-efficient and safety network cabinet in accordance with the present invention.
FIG.2 is the schematic diagram of the intelligent modular energy-efficient and safety network cabinet mounted on the floor in accordance with the present invention, which defines a recycle way that the air is in from the bottom and out from the top.

### DETAILED DESCRIPTION OF THE INVENTION

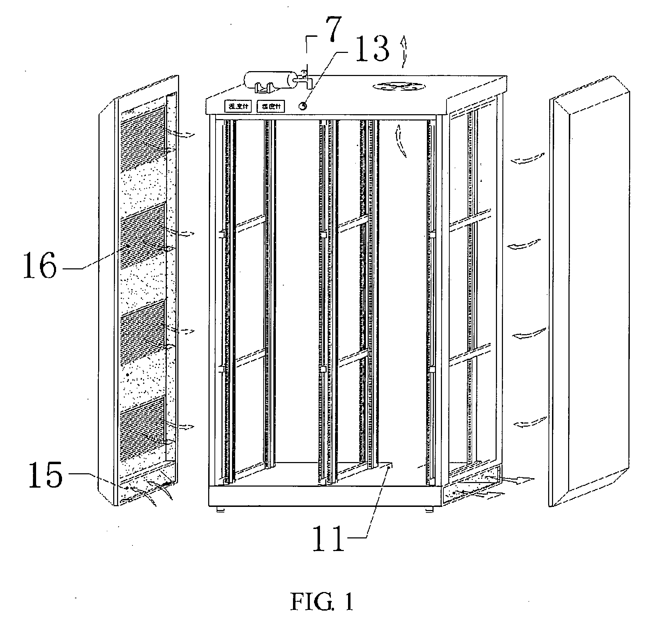

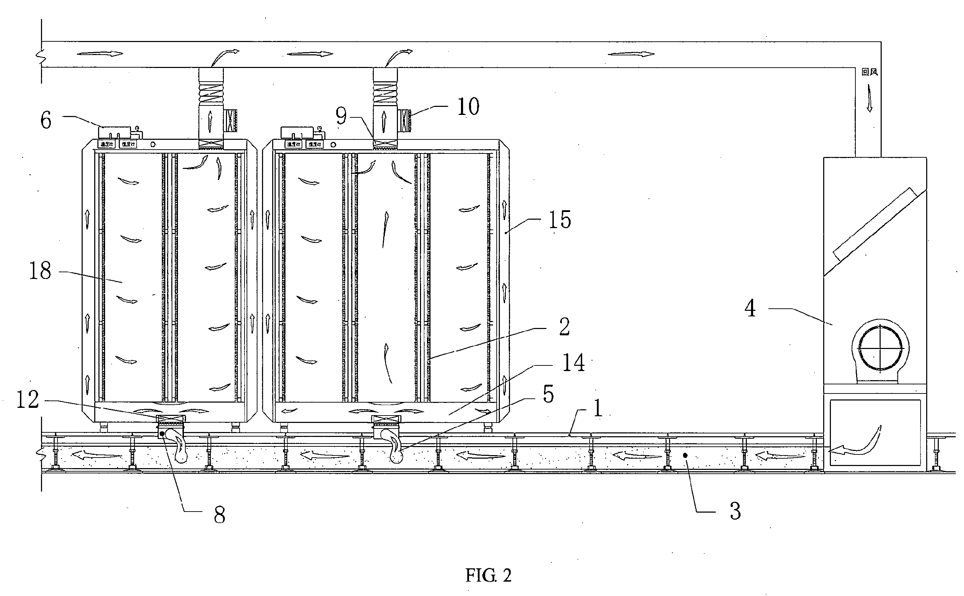

Referring to FIG. 1 and FIG. 2, an intelligent modular energy-efficient and safety network cabinet, located on the floor 1 of the room, includes:
(a) at least one cabinet body 2, designed according to the match equipment, is actually detachable which belongs to the combination of the standard manufacture unit, it may be specially manufactured according to the actual equipment;
(b) a main blast pipe 3, used to transfer air between an air-conditioner and the cabinet body 2;
(c) at least one tributary blast pipe 5, connected the main blast pipe 3 and the cabinet body 2;
(d) a fire extinguisher 6, disposed above the cabinet body 1 and full with inert-gas;
(e) an induction pipe 7, connecting the fire extinguisher 6 and the cabinet body 1;
(f) a force draft fan 8, disposed under the cabinet body 1;
(g) a return fan 9, disposed above the cabinet body 1;
(h) an exhaust smoke valve 10, disposed above the return fan 9;
(i) a line inlet and outlet 11 for strong-and-weak current, disposed at the bottom of the cabinet body 1;
(j) a detachable cover, and used to avoid cold air flowing away from the inside to the outside of the cabinet body;
(k) a control system, used to control the temperature and humidity of the cabinet body 2 and to put out fire.

Wherein the control system comprises a temperature sensor, a humidity sensor, a smoke sensor, and other elements (not shown in figures). Both a thermometer and a hygrometer are disposed outside the cabinet body 2 and are connected with the control system, so the temperature and humidity of the cabinet body 2 are known.

Wherein an air guide device 12 is disposed on the junction of the tributary blast pipe 5 and the cabinet body 2, and the force draft fan 8 is under the air guide device 12.

When the fire alarms occurs in one cabinet body 2, the control system lets the corresponding force draft fan 8 and return fan 9 close automatically, the fire extinguisher 6 will emit inert-gas and ensure the pressure in the cabinet body. Putting out a fire inside one or more special cabinet body 2, which avoids the whole firefighting gas breaking out in a flash that may cause the damage of other cabinet bodies and, the unescaped is threaten by the asphyxia death.

A fire valve 13 is disposed on the side of the fire extinguisher 6, and the fire extinguisher 6 is able to control the ejection of inert-gas manually or automatically. Until the fire alarm is over, an exhaust smoke valve 10 above the return fan 9 will work during a set time in order to effluent gas and smoke.

A bottom air intake duct 14 is disposed at the bottom of the cabinet body 2 connected to the tributary blast pipe 5, and two side air intake ducts 15, which is connected to the bottom air intake duct 14, comprising air supply louvers 16 used to transfer air into the cabinet body 2, are disposed on both sides of the cabinet body 2 respectively. The air from the air conditioner passes through the main blast pipe 3 at first, and then through the tributary blast pipe 5, and then through the bottom air intake duct 14 and side air-intake ducts 15, and then through the air supply louvers 16 into the cabinet body 2.

Furthermore, the total supply air volume and return air volume are controlled respectively by the force draft fan 8 and the return fan 9, however, the force draft fan 8 and the return fan 9 are adjusted automatically by the control system according to the temperature and humidity inside the cabinet body 2, thus the temperature and humidity inside the cabinet body 2 would be keep an ideal condition.

Two gas pressure relief openings, where is an pressure release valve mounted on, are formed on a sheathing of the line inlet and outlet at the bottom of the cabinet body 2, which prevents damage to the equipment due to the over large pressure inside the cabinet body 2 when the inert-gas breaks out.

In the present invention, the independent control of power supply and point-to-point fire fighting make the cabinet bodies 2 safe and energy-efficient, for it is able to automatically cut off its own power in case of fire, and do not impact the work of other cabinet bodies. In such a case, the fire extinguisher starts working and puts out the fire just in a special cabinet body. Thus, it can reduce the gas consumption and improve the accuracy. And also, it can avoid all the gas being sprayed in one time and avoid the wasting. In addition, it prevents all the equipment from being out of service or scraped, the network from denial of service and the people from being died of asphyxiation.

The cabinet body 2 is mounted with a fireproof and heat insulation glass door 18, which makes it convenient to maintain the equipment and observe the working condition. At the bottom of the cabinet body 2, there are also line inlet and outlet. The temperature and the humidity, fire extinguisher and linked system for power supplies are all intelligently and automatically controlled, accompanied with the essential auxiliary manual control. The cabinet body 2 is mounted by combination of the separative standard modules, so that it can be maintained and transported conveniently.

In accordance with the present invention, the equipment is inside cabinet body 2. Only the space of the cabinet body is taken into consideration to set the constant temperature and humidity. For the outside space of the cabinet body 2, the common air conditioners may be chosen, and this makes the total power of the air conditioners 4 efficiently decreased and makes the energy saved. In addition, the firefighting gas depends on the space of each cabinet body 2, in order to minimize the fire area and to put out the fire accurately. And for the outside space of the cabinet body 2, the common fire extinguishers may be chosen, so the volume of reserve gas is decreased, what's more, this avoids the waste of the gas being released in one time and the hurt of the people. Therefore, the modular energy-efficient safety cabinet is high efficient, energy saving, safe and the lower cost.

While the present invention has been illustrated by the above description of the preferred embodiments thereof, while the preferred embodiments have been described in considerable detail, it is not intended to restrict or in any way limit the scope of the appended claims to such details. Other advantages and modification within the spirit and scope of the present invention will readily appear to those skilled in the art. Therefore, the present invention is not limited to the specific details and the illustrative examples shown and described.

## Claims

1. A modular energy-efficient and safety network cabinet operating with a main blast pipe (3) transferring air of an air-conditioner (4), comprising:
at least one cabinet body (2);
at least one tributary blast pipe (5), connected the main blast pipe (3) and the cabinet body (2);
a force draft fan (8), disposed under the cabinet body (2);
a return fan (9), disposed above the cabinet body (2);
a fire extinguisher (6), disposed above the cabinet body (2) and full with inert gas;
an induction pipe (7), connecting the fire extinguisher (6) and the cabinet body (2);
an exhaust smoke valve (10), disposed above the return fan (9);
a line inlet and outlet (11) for strong-and-weak current, disposed at the bottom (1) of the cabinet body (2);
a gas pressure relief opening, disposed at the bottom (1) of the cabinet body (2);
a control system, used to control the temperature and humidity of the cabinet body (2) and to put out fire;
wherein when a fire alarm occurs in the network cabinet, the control system closes automatically the force draft fan (8) and return fan (9) the fire extinguisher (6) emits inert-gas and ensures a pressure in the cabinet body (2); and
wherein until the fire alarm is over, the exhaust smoke valve (10) works during a set time in the order to effluent gas and smoke.

2. The modular energy-efficient and safety network cabinet of claim 1, wherein an air guide device (12) is disposed on the junction of the tributary blast pipe (5) and the cabinet body (2), and the force draft fan (8) is under the air guide device (12).

3. The modular energy-efficient and safety network cabinet of claim 1, wherein a bottom air intake duct (14) is disposed at the bottom of the cabinet body (2) connected to the tributary blast pipe (5), and two side air-intake ducts (15), which is connected to the bottom air-intake duct (14), comprising air supply louvers (16) used to transfer air into the cabinet body (2), are disposed on both sides of the cabinet body (2) respectively.

4. The modular energy-efficient and safety network cabinet of claim 1, wherein the fire extinguisher (6) comprises a fire valve (13).

5. The modular energy-efficient and safety network cabinet of claim 1, wherein the control system comprises a temperature sensor, a humidity sensor, and a smoke sensor.

6. The modular energy-efficient and safety network cabinet of claim 1, wherein the cabinet body (2) is mounted with a fireproof and heat insulation glass door (18).

7. The modular energy-efficient and safety network cabinet of claim 1, wherein a line inlet and outlet (11) for strong-and-weak current is disposed at the bottom of the cabinet body (2), a gas pressure relief opening is disposed at the bottom of the cabinet body (2).

8. The modular energy-efficient and safety network cabinet of claim 1, wherein both a thermometer and a hygrometer are disposed outside the cabinet body (2) and are connected with the control system.

9. The modular energy-efficient and safety network cabinet of claim 1, wherein the temperature, the humidity, the fire extinguisher (6), and the linked system for power supplies are all intelligently and automatically controlled, accompanied with the essential auxiliary manual control.

10. The modular energy-efficient and safety network cabinet of claim 1, wherein the cabinet body (2) is mounted by combination of separative standard modules.

## Patentansprüche

1. Ein modularer, energieeffizienter und sicherheitsrelevanter Netzschrank mit einem Hauptabluftrohr (3) für die Luftübertragung aus der Klimaanlage (4), umfassend:
mindestens ein Schrankgehäuse (2);
mindestens einen Nebenrohr (5), das am Hauptrohr (3) und Schrankgehäuse (2) angeschlossen wird;
ein Gebläse (8) für Zwangsentlüftung, angeordnet unter dem Schrankgehäuse (2);
ein Gebläse (9) für Rücklauf, angeordnet über dem Schrankgehäuse (2);
einen Feuerlöscher (6), angeordnet über dem Schrankgehäuse (2) und gefüllt mit Inertgas;
einen Induktionsrohr (7), angeschlossen zwischen dem Feuerlöscher (6) und dem Schrankgehäuse (2);
ein Abgasrauchventil (10), angeordnet über dem Abluftgebläse (9);
eine Einlass- und Auslasslinie (11) für starke und schwache Strömung, angeordnet unten (1) am Schrankgehäuse (2);
eine Öffnung für Gasdruckentlastung, angeordnet unten (1) am Schrankgehäuse (2);
einer Steuerung für die Temperatur- und Feuchtigkeitskontrolle im Schrankgehäuse (2) sowie für die Feuerlöschung;
wobei der Feueralarm im Netzschrank auslöst, werden die Gebläsen für Zwangsentlüftung (8) und Rücklauf (9) automatisch durch die Steuerung geschlossen, während der Feuerlöscher (6) das Inertgas ausstießt und den erforderlichen Druck im Schrankgehäuse (2) gewährleistet;
Solange der Feueralarm aktiv ist, funktioniert das Abgasrauchventil (10) ordnungsgemäß eine eingestellte Zeit lang, um das Gas und den Rauch fortzuführen.

2. Der modulare, energieeffiziente und sicherheitsrelevante Netzschrank nach Anspruch 1, wobei das Luftführungsstück (12) an der Verbindung zwischen dem Nebenrohr (5) und dem Schrankgehäuse (2) angeschlossen ist, und das Gebläse für Zwangsentlüftung (8) unter dem Luftführungsstück liegt (12).

3. Der modulare, energieeffiziente und sicherheitsrelevante Netzschrank nach Anspruch 1, wobei das untere Zuluftrohr (14) unten am Schrankgehäuse (2) angeordnet und am Nebenrohr (5) angeschlossen ist, während die beidseitigen Lufteinlässe (15), verbunden mit dem unteren Lufteinlassrohr (14) und bestehend aus Luftversorgungslamellen (16) zur Übertragung von Luft in das Schrankgehäuse (2), auf beiden Seiten des Schrankgehäuses (2) angeordnet sind.

4. Der modulare, energieeffiziente und sicherheitsrelevante Netzschrank nach Anspruch 1, wobei der Feuerlöscher (6) eine Feuerklappe (13) beinhaltet.

5. Der modulare, energieeffiziente und sicherheitsrelevante Netzschrank nach Anspruch 1, wobei die Steuerung einen Temperatur-, einen Feuchtigkeits- und einen Rauchsensor beinhaltet.

6. Der modulare, energieeffiziente und sicherheitsrelevante Netzschrank nach Anspruch 1, wobei das Schrankgehäuse (2) eine feuerfeste und gedämmte Glastür (18) beinhaltet.

7. Der modulare, energieeffiziente und sicherheitsrelevante Netzschrank nach Anspruch 1, wobei die Einlass- und Auslasslinie (11) für starke und schwache Strömung und die Öffnung für Gasdruckentlastung unten am Schrankgehäuse (2) angeordnet sind.

8. Der modulare, energieeffiziente und sicherheitsrelevante Netzschrank nach Anspruch 1, wobei ein Thermometer und ein Hygrometer außerhalb des Schrankgehäuses (2) angeordnet und mit der Steuerung verbunden sind.

9. Der modulare, energieeffiziente und sicherheitsrelevante Netzschrank nach Anspruch 1, wobei die Temperatur, die Feuchtigkeit, der Feuerlöscher (6) und das verbundene System für die Spannungsversorgung intelligent und automatisch gesteuert werden, erweitert mit den zusätzlichen manuellen Bedienungsmöglichkeiten.

10. Der modulare, energieeffiziente und sicherheitsrelevante Netzschrank nach Anspruch 1, wobei das Schrankgehäuse (2) durch eine Kombination von separaten Standardmodulen montiert wird.

## Revendications

1. Une armoire modulaire économe en énergie et du réseau de sécurité fonctionnant avec une tuyère principale (3) transférant l'air d'un climatiseur (4), comprenant:
au moins un corps de l'armoire (2);
au moins une tuyère tributaire (5), connectée à la tuyère principale (3) et au corps de l'armoire (2);
un ventilateur à tirage forcé (8), disposé sous le corps de l'armoire (2);
un ventilateur de retour (9), disposé au-dessus du corps de l'armoire (2);
un extincteur (6), disposé au-dessus du corps de l'armoire (2) et rempli de gaz inerte;
un tuyau d'induction (7), connectant l'extincteur (6) et le corps de l'armoire (2);
une valve de fumée d'échappement (10), disposée au-dessus du ventilateur de retour (9);
un conduit d'entrée et de sortie (11) pour un courant fort et faible, disposé en bas (1) du corps de l'armoire (2);
une ouverture pour la décompression de gaz, disposée en bas (1) du corps de l'armoire (2);
un système de contrôle, utilisé pour contrôler la température et l'humidité du corps de l'armoire (2) et pour éteindre le feu;
dans laquelle lorsque l'alarme incendie se déclenche dans l'armoire du réseau, le système de contrôle ferme automatiquement le ventilateur à tirage forcé (8) et le ventilateur de retour (9) l'extincteur (6) dégage du gaz inerte et garantit une pression dans le corps de l'armoire (2); et
dans laquelle jusqu'à ce que l'alarme incendie s'arrête, la valve de fumée d'échappement (10) fonctionne pendant un temps déterminé afin d'évacuer les effluents de gaz et de fumée.

2. L'armoire modulaire économe en énergie et du réseau de sécurité selon la revendication 1, dans laquelle un dispositif de guidage d'air (12) est disposé à la jonction de la tuyère tributaire (5) et du corps de l'armoire (2), et leventilateur à tirage forcé (8) est sous le dispositif de guidage d'air (12).

3. L'armoire modulaire économe en énergie et du réseau de sécurité selon la revendication 1, dans laquelle un conduit d'admission d'air inférieur (14) est disposé en bas du corps de l'armoire (2) connecté à la tuyère tributaire (5), et deux conduits d'admission d'air latéraux (15), qui sont connectés au conduit d'admission d'air inférieur (14), comprenant des persiennes d'alimentation en air (16) utilisées pour transférer l'air dansle corps de l'armoire (2), qui sont disposés sur les deux côtés du corps de l'armoire (2) respectivement.

4. L'armoire modulaire économe en énergie et du réseau de sécurité selon la revendication 1, dans laquelle l'extincteur (6) comprend une valve coupe-feu (13).

5. L'armoire modulaire économe en énergie et du réseau de sécurité selon la revendication 1, dans laquelle le système de contrôle comprend un capteur de température, un capteur d'humidité, et un détecteur de fumée.

6. L'armoire modulaire économe en énergie et du réseau de sécurité selon la revendication 1, dans laquelle le corps de l'armoire (2) est monté avec une porte en verre à l'épreuve du feu et capable d'isolation thermique (18).

7. L'armoire modulaire économe en énergie et du réseau de sécurité selon la revendication 1, dans laquelle un conduit d'entrée et de sortie (11) pour un courant fort et faible est disposé en bas du corps de l'armoire (2), une ouverture pour la décompression de gaz est disposée en bas du corps de l'armoire (2).

8. L'armoire modulaire économe en énergie et du réseau de sécurité selon la revendication 1, dans laquelle un thermomètre et un hygromètre sont disposés à l'extérieur du corps de l'armoire (2) et sont connectés au système de contrôle.

9. L'armoire modulaire économe en énergie et du réseau de sécurité selon la revendication 1, dans laquellela température, l'humidité, l'extincteur (6), et le système pour les sources d'alimentation lié sont tous intelligemment et automatiquement contrôlés, accompagnés du contrôle manuelauxiliaire indispensable.

10. L'armoire modulaire économe en énergie et du réseau de sécurité selon la revendication 1, dans laquelle le corps de l'armoire (2) est monté grâce à la combinaison de modules standard séparatifs.
